Europäisches Patentamt

European Patent Office

Office européen des brevets

(19)

(11) Publication number: **0 324 890 B1**

## EUROPEAN PATENT SPECIFICATION

(12)

(45) Date of publication of patent specification: **15.07.92**   (51) Int. Cl.⁵: **H05K 7/20**

(21) Application number: **88106433.1**

(22) Date of filing: **22.04.88**

(54) **Printed wiring board.**

(30) Priority: **18.12.87 JP 320611/87**

(43) Date of publication of application:
**26.07.89 Bulletin 89/30**

(45) Publication of the grant of the patent:
**15.07.92 Bulletin 92/29**

(84) Designated Contracting States:
**BE DE ES FR GB IT NL**

(56) References cited:
**FR-A- 2 480 488**

**JOURNAL OF ELECTRONIC ENGINEERING,
vol. 22, no. 226, October 1985, pages 56-60,
Tokyo, JAPAN; YAMAHIRO IWASA: "Materials
Research Refines Oualities of Resistive
Paste for Microelectronics"**

**idem**

(73) Proprietor: **Nippon CMK Corp.
1106 Fujikubo Miyoshi-Chou
Iruma-Gun Saitama(JP)**

(72) Inventor: **Kawakami, Shin
2-112 Sakurayamadai
Higashimatsuyama-shi Saitama(JP)**
Inventor: **Haruyama, Satoshi
390 Mitsugi
Fujioka-shi Gunma(JP)**
Inventor: **Okonogi, Hirotaka
1808-2 Naganuma-cho
Isezaki-shi Gunma(JP)**
Inventor: **Nikaido, Katsutomo
256-3 Shibamachi
Isezaki-shi Gunma(JP)**
Inventor: **Ichikawa, Junichi
3158-2 Fujiok
Fujioka-shi Gunma(JP)**

(74) Representative: **Schickedanz, Willi, Dipl.-Ing.
Langener Strasse 68
W-6050 Offenbach/Main(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

# Description

## Technical Field to which the Invention relates

The present invention relates to a printed wiring board.

## Description of the Prior Art

As one of the conventional methods of mounting a desired resistor across printed wiring circuits, a carbon resistor is mounted by printing across printed wiring circuit terminals. This method is widely adopted to simplify the mounting operation of resistors on the printed wiring board, and to enable a small size printed wiring board.

On the circuit conductor of a thus formed printed wiring board an overcoat formed by printed insulating film is deposited; see for example the Journal of Electronic Engineering, vol. 22, no. 226, October 1985, pages 56-60, Tokyo, Japan.

## Disadvantages of the Prior Art

Such conventional printed wiring board of the above described construction includes disadvantages such that heat produced during operation in the carbon resistor and circuit conductor cannot sufficiently dissipate owing to the insulation film which acts as effective electrical and thermal insulation to the resistor and circuit conductor. Consequently, the resistor and a portion of circuit conductor may be overheated to cause thermal noise which is main cause of erroneous operation.

## Technical Problem

The object of the present invention is to eliminate or at least mitigate the above mentioned disadvantage and to provide an improved printed wiring board which effectively prevents the resistor and circuit conductor from producing thermal noise and from erroneous operation in the circuit.

## Solution of the Technical Problem

To solve the above problem, a heat dissipating film layer is formed at least on the carbon resistor.

Preferably, the heat dissipating film layer is formed by a printed film layer.

Preferably, the heat dissipating film layer is formed by a film layer which is formed by paste-like ink which is made from copper particles coated by silver and is formed by a printing process.

Preferably, the heat dissipating film layer is formed on an overcoat film layer which covers the carbon resistor.

## Advantageous Effect of the Invention

The printed wiring board, according to the present invention, performs a positive heat dissipating effect by the heat dissipating film layer formed on the carbon resistor so that heat produced in the carbon resistor during operation of the printed wiring board can be dissipated effectively even when the insulating overcoat film covers the carbon resistor.

## Brief Description of the Drawings

Fig. 1 is an enlarged sectional view of a portion of a printed wiring board according to one embodiment of the present invention.

Figure 2 is an enlarged sectional view of a portion of a conventional printed wiring board.

## Detailed Description of the Prior Art and of the Preferred Embodiment

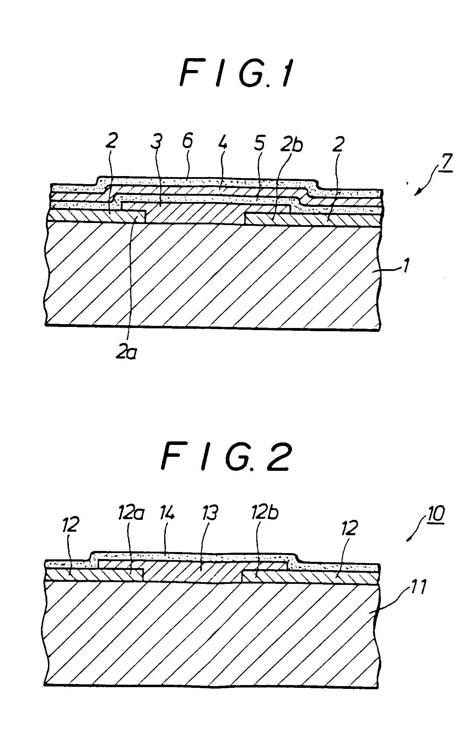

Fig. 2 shows a conventional printed wiring board 10 which includes a base plate 11 made of insulating material, a printed wiring circuit 12 formed on the base plate 11, terminals 12a and 12b of the circuit 12, a carbon resistor 13 across the terminals 12a and 12b and formed by printing process of carbon paste, and an overcoat film layer 14 formed by a printing process of insulating paste and covering the circuit 12 and the carbon resistor 13. The disadvantage of this structure has been described above.

Now, one preferred embodiment of the printed wiring board according to the present invention will be described in connection with the drawing.

Referring to Fig. 1 which shows one embodiment of the present invention, a base plate 1 made from insulating material and a desired printed wiring circuit 2 formed on the base plate 1 are shown. A carbon resistor 3 is formed across the terminals 2a and 2b of the printed wiring circuit 2. The carbon resistor 3 is made of suitable carbon paste ink of a desired composition. It is first formed by a printing process between the terminals 2a and 2b and then hardened. On the printed wiring circuit 2 having the carbon resistor 3 an overcoat film layer 5 is covered by a printing process.

A heat dissipating film layer 4 covers the carbon resistor 3 and the desired circuit 2 through the overcoat film layer 5.

The heat dissipating film layer 4 may preferably be made from heat dissipating paste ink, e.g. silver coated copper particles, which is sold by Fujikura Kasei Co. Ltd. as Silver compound copper paste EX-019. The paste is formed as a carbon resistor across the terminals by printing process and is then hardened.

The heat dissipating film layer 4 may have a composition other than above mentioned composition to attain a heat dissipating effect with respect to the heat produced by the carbon resistor 3.

An overcoat film layer 6 is formed on the heat dissipating film layer 4.

As described, the printed wiring board 7, according to the present invention, positively dissipates heat produced in the carbon resistor 3 across the circuit terminals 2a and 2b during operation so that the thermal noise caused by heat and, as a result, erroneous operation in the circuit 2 are prevented from occuring. Thus, a printed wiring board having superior characteristic is provided.

## Claims

1. A printed wiring board (7) including at least one carbon resistor (3) formed between terminals (2a, 2b) of printed wiring circuit (2), **characterized in that** a heat dissipating film layer (4) is formed at least on the carbon resistor (3).

2. A printed wiring board according to claim 1, **characterized in that** the heat dissipating film layer (4) is formed by printed film layer.

3. A printed wiring board according to claim 1, **characterized in that** the heat dissipating film layer (4) is formed by a film layer which is formed by a paste-like ink which comprises copper particles coated by silver and which is formed by a printing process.

4. A printed wiring board according to claim 1, **characterized in that** the heat dissipating film layer (4) is formed on an overcoat film layer (5) which covers the carbon resistor.

5. A printed wiring board according to claim 1, **characterized in that** an overcoat film layer (6) is formed on the heat dissipating film layer (4).

## Revendications

1. Plaque à circuit imprimé (7) comprenant au moins une résistance de carbone (3) disposée entre des bornes (2a, 2b) du circuit imprimé (2), caractérisée en ce qu'une fine couche dissipant la chaleur (4) est formée au moins sur la résistance de carbone (3).

2. Plaque à circuit imprimé selon la revendication 1, caractérisée en ce que la fine couche dissipant la chaleur (4) est constituée par une fine couche imprimée.

3. Plaque à circuit imprimé selon la revendication 1, caractérisée en ce que la fine couche dissipant la chaleur (4) est constituée par une fine couche formée d'une encre pâteuse comprenant des particules de cuivre recouvertes d'argent, ladite couche étant formée par un procédé d'impression.

4. Plaque à circuit imprimé selon la revendication 1, caractérisée en ce que la fine couche dissipant la chaleur (4) est formée sur une fine couche de revêtement (5) recouvrant la résistance de carbone.

5. Plaque à circuit imprimé selon la revendication 1, caractérisée en ce qu'une fine couche de recouvrement (6) est formée sur la fine couche dissipant la chaleur (4).

## Patentansprüche

1. Gedruckte Leiterplatte (7), mit wenigstens einem Kohlewiderstand (3), der zwischen Anschlüssen (2a, 2b) der gedruckten Schaltung (2) vorgesehen ist, **dadurch gekennzeichnet, daß** eine Hitze abgebende Schicht (4) wenigstens auf dem Kohlewiderstand (3) angebracht ist.

2. Gedruckte Leiterplatte nach Anspruch 1, **dadurch gekennzeichnet, daß** die Hitze abgebende Schicht (4) aus einer gedruckten Filmschicht besteht.

3. Gedruckte Leiterplatte nach Anspruch 1, **dadurch gekennzeichnet, daß** die Hitze abgebende Schicht (4) eine Filmschicht ist, die aus einer pastenförmigen Tinte besteht, welche mit Silber beschichtete Kupferpartikel enthält und die durch einen Druckprozeß aufgebracht ist.

4. Gedruckte Leiterplatte nach Anspruch 1, **dadurch gekennzeichnet, daß** die Hitze abgebende Schicht (4) auf einer Mantelschicht (5) aufgebracht ist, welche den Kohlewiderstand abdeckt.

5. Gedruckte Leiterplatte nach Anspruch 1, **dadurch gekennzeichnet, daß** eine Mantelschicht (6) auf der Hitze abgehenden Schicht (4) aufgebracht ist.

# F I G.1

# F I G.2

4